# FASCICULE DE BREVET EUROPEEN

(11) **EP 2 901 496 B1**
(45) Date de publication et mention de la délivrance du brevet: **01.08.2018**
(21) Numéro de dépôt: 13779754.4
(22) Date de dépôt: 27.09.2013
(51) Int. Cl.: H01L 31/0352, H01L 31/055

(54) **COMPOSANT PHOTOVOLTAIQUE A FORT RENDEMENT DE CONVERSION**
FOTOVOLTAIKKOMPONENTE MIT HOHER UMWANDLUNGSEFFIZIENZ
PHOTOVOLTAIC COMPONENT WITH A HIGH CONVERSION EFFICIENCY

(30) Priorité: 28.09.2012 FR 1259225
(43) Date de publication de la demande: 05.08.2015
(73) Titulaire: Centre National de la Recherche Scientifique (C.N.R.S.), 75794 Paris Cedex 16 (FR); Electricité de France (EDF), 75008 Paris (FR); Université Pierre et Marie Curie (Paris 6), 75252 Paris Cedex 05 (FR)
(72) Inventeur: PELOUARD, Jean-Luc, 75020 Paris (FR); GUILLEMOLES, Jean-François, 75013 Paris (FR); PROISE, Florian, 75014 Paris (FR); PAIRE, Myriam, 75017 Paris (FR); LINCOT, Daniel, 92160 Antony (FR)
(74) Mandataire: Osha Liang
(86) Numéro de dépôt international: PCT/EP2013/070286
(87) Numéro de publication internationale: WO 2014/049157

(56) Documents cités:
- FR-A1- 2 959 352
- US-A1- 2010 126 566
- US-A1- 2011 011 436
- US-A1- 2011 013 253
- US-A1- 2012 112 165

## Description

### ETAT DE L'ART

### Domaine technique de l'invention

La présente invention concerne un composant photovoltaïque à rendement de conversion amélioré et son procédé de fabrication.

### Etat de l'art

Il a été démontré que le rendement de conversion des cellules solaires augmente avec l'intensité du flux lumineux incident, tant que les pertes par effet Joule résultant des chutes de tension électrique dans les zones résistives de la cellule, restent faibles (voir par exemple M. Paire et al., « Microscale solar cells for high concentration on polycristalline Cu(In, Ga)Se2 thin films », Appl. Phys. Letters 98, 264102 (2011)). Il est montré dans l'article de M. Paire et al. qu'il est possible avec des cellules de faible diamètre (de 10 à 500 microns) d'atteindre des rapports de concentration élevés (jusqu'à 475), le rapport de concentration étant défini par le rapport du flux de photons entrant dans la cellule au flux incident mesuré en champ lointain, tout en limitant les pertes résistives. Ceci a permis notamment d'augmenter de 5 points le rendement de conversion, défini comme le rapport de la puissance électrique produite sur la puissance optique incidente. La concentration du flux lumineux incident permet également de réduire la consommation des matières premières à coût de revient élevé, l'aire du matériau en semi-conducteur nécessaire à la réalisation de cellules étant réduite par le facteur de concentration. Ceci est particulièrement important pour la filière à base de couches minces, notamment la filière à base de matériaux chalcopyrites, du fait de la disponibilité limitée à long terme de l'indium et du tellure.

Cependant la concentration de la lumière solaire sur une cellule photovoltaïque ne se fait pas sans difficultés. La lumière solaire arrive sur T̅erre au niveau du sol sous deux formes, directe et diffuse. La lumière directe (rayons issus du soleil) peut être concentrée par un système optique imageant. Ce dernier, pour rester efficace, doit suivre précisément le mouvement apparent du soleil durant toute la journée. La lumière diffuse (diffusion par l'atmosphère) est, quant à elle, perdue dans ces systèmes imageants. Il existe des systèmes non-imageants qui permettent de concentrer la lumière diffuse (voir par exemple T. Warabizaco et al. « Static concentrator module with prism array », Solar energy Materials and Solar cells, 67, 415 - 423 (2001) ou R. Winston et al., «Nonimaging optics » Elsevier Academic Press (2005)), mais leur facteur de concentration reste modeste (i.e. inférieur à 4).

Un système de concentration de la lumière non imageant connu est le concentrateur fluorescent (R. Reisfeld et al., « Luminescent Solar concentrators for Energy Conversion », Solar Energy materials, 49, 1 (1982)). Il fonctionne comme une cavité collectant la lumière solaire sur une grande aire pour la guider vers une zone de plus petite taille, au niveau de laquelle est positionnée une (voire plusieurs) cellule(s) photovoltaïque(s). Ce système a l'avantage de collecter la lumière du soleil pour tous les angles d'incidence, donc de bénéficier à la fois des composantes directes et diffuses de la lumière solaire. Ainsi aucun système de suivi précis du soleil n'est nécessaire. Par contre, ce système présente de nombreuses pertes, en particulier celles dues aux réflexions multiples dans le guide d'onde. De ce fait, les facteurs de concentration restent très faibles.

Les nano-antennes optiques de type MIM (métal isolant métal) ont montré des capacités remarquables en terme de collection de la lumière dans de très petits volumes. En effet elles peuvent présenter, à la résonance, une absorption quasi parfaite, indépendante de l'angle d'incidence sur une très large plage angulaire (typiquement entre -70 et +70 degrés) et des volumes de cavité aussi petits que λ³/1000 (A. Cattoni et al., «λ3/1000 plasmonic nanocavities for biosensing fabricated by Soft UV Nanoimprint Lithography », Nano Lett. 11(9) 3557 (2011)). Le caractère résonant de ces antennes, dû au confinement dans une cavité optique de modes plasmoniques couplés se propageant aux interfaces métal - diélectrique, leur confère une largeur spectrale très petite devant celle du spectre solaire (typiquement une largeur à mi-hauteur égale à moins du dixième de la longueur d'onde de résonance). Des structures MIM asymétriques dédiées à la réalisation de cellules photovoltaïques ont été montrées dans la demande de brevet français publiée FR 2959352. Elles sont basées sur la présence simultanée de plusieurs résonances pour couvrir une large part du spectre solaire. Bien que très efficaces, ces structures présentent des contraintes de dimensionnement fortes pour concilier les conditions d'une multi-résonance dans le spectre solaire avec un matériau semi-conducteur donné.

Un objet de la présente invention est la réalisation d'un composant photovoltaïque à concentration utilisant des nano-antennes optiques, par exemple de type MIM, présentant par rapport aux composants photovoltaïques existants un rendement de conversion amélioré et une consommation réduite des matériaux nécessaires à la fonction photovoltaïque.

### RESUME DE L'INVENTION

Selon un premier aspect, l'invention concerne un composant photovoltaïque comprenant au moins un premier ensemble de nano-cellules photovoltaïques comprenant chacune une nano-antenne optique présentant une résonance électromagnétique dans une première bande spectrale de résonance, au moins une dimension latérale de la nano-antenne optique étant sub longueur d'onde, c'est-à-dire inférieure à une longueur d'onde centrale de la dite bande spectrale de résonnance, et une couche de conversion spectrale permettant la conversion d'au moins une partie du spectre solaire vers ladite première bande spectrale de résonance.

Le composant photovoltaïque selon la présente description crée une synergie entre un concentrateur spatial - les nano-antennes optiques - et un concentrateur spectral - la couche de conversion spectrale - de telle sorte à permettre un taux d'absorption optimisé des photons incidents par le composant photovoltaïque. La couche de conversion spectrale permet notamment d'utiliser les nano-antennes optiques dans un mode de fonctionnement d'un résonateur électromagnétique à résonance simple, ce qui permet d'obtenir une absorption quasiment totale dans la bande spectrale de résonance et de ce fait un excellent rendement de conversion du composant photovoltaïque.

Selon une variante, le composant photovoltaïque comprend une première couche métallique continue et chaque nano-cellule photovoltaïque comprend un empilement structuré d'une première couche diélectrique et d'une seconde couche métallique pour former avec la première couche métallique continue une nano-antenne optique de type MIM (pour métal/isolant/métal). Cette configuration particulière du composant photovoltaïque permet l'agencement de nano-antennes de type MIM, qui présentent une excellente capacité à concentrer le flux lumineux incident.

Les structures dites de type « MIM » comprennent de façon connue un empilement d' une première couche métallique, d'une première couche diélectrique et d'une seconde couche métallique.

En électromagnétisme, on appelle milieu diélectrique un milieu permettant la propagation des ondes, et en particulier de la lumière. Un milieu de propagation est caractérisé à une longueur d'onde donnée par une constante diélectrique définie par le carré de l'indice de réfraction. Dans le cas où le milieu de propagation présente des pertes (absorption), la constante diélectrique et l'indice de réfraction deviennent des nombres complexes. Un matériau diélectrique présente un indice de réfraction avec une partie réelle dominante contrairement à un métal dans lequel la partie imaginaire de l'indice de réfraction domine. Sauf aux énergies de photons supérieures à la largeur de bande interdite, les semi-conducteurs sont des milieux diélectriques à faible pertes. Lorsque des charges électriques libres sont produites par dopage ou par illumination, la constante diélectrique des semi-conducteurs varie très peu (de moins de un pour mille) aux fréquences optiques. Un matériau semi-conducteur est un matériau diélectrique aux fréquences optiques.

Ainsi la partie diélectrique des résonateurs MIM peut comprendre, selon une variante, un empilement de couches adapté à la réalisation d'un dispositif photovoltaïque, par exemple un empilement de couches en matériau semi-conducteur, organique, inorganique ou hybride. L'empilement de couches en matériau semi-conducteur comprend par exemple une couche en matériau semi-conducteur absorbant dans ladite première bande spectrale de résonance et, de part et d'autre de la couche en matériau semi-conducteur absorbant, une couche ou un empilement de couches en matériau semi-conducteur dopé en contact avec les première et seconde couches métalliques respectivement. La couche ou l'empilement de couches en matériau semi-conducteur dopé en contact avec la seconde couche métallique structurée contribue à former un contact électrique des nano-cellules photovoltaïques.

Selon une variante, l'ensemble des couches formant la partie diélectrique des résonateurs MIM sont structurées. Alternativement, seule la couche ou empilement de couches en matériau semi-conducteur dopé assurant le contact électrique avec la seconde couche métallique est structuré(e).

Les nano-cellules photovoltaïques peuvent comprendre des matériaux semi-conducteurs inorganiques, par exemple des couches en arséniure de gallium et alliages associés, en phosphure d'indium et alliages associés, en arséniure de gallium et d'indium et alliages associés, en antimoniure de gallium et alliages associés. Les nano-cellules photovoltaïques peuvent également comprendre des matériaux semi-conducteurs organiques ou hybrides.

Selon une variante, une dimension latérale de chaque nano-antenne optique MIM est inférieure à λ₀/5 où λ₀ est une longueur d'onde centrale de ladite première bande spectrale de résonance, c'est-à-dire une longueur d'onde de la bande spectrale de résonance pour laquelle l'absorption présente un maximum. En choisissant au moins une dimension latérale inférieure à λ₀/5, on conserve le mode vertical du résonateur tout en réduisant les courants d'obscurité proportionnels à la surface de la jonction.

Selon une variante, les nano-antennes optiques MIM présentent une forme de ruban et sont disposées selon une orientation principale. Les secondes couches métalliques d'au moins une partie des nano-antennes optiques MIM peuvent alors être reliées pour former un contact électrique supérieur pour le premier ensemble de nano-cellules photovoltaïques. Selon une variante, les nano-antennes optiques MIM peuvent être sensiblement identiques, réparties de façon périodique ou quasi-périodique. Alternativement, la largeur des rubans peut présenter des variations sur une quasi-période inférieure à la longueur d'onde, par exemple sous forme de marches ou de biseaux, de façon à élargir la réponse spectrale et ainsi adapter au mieux la plage d'absorption du résonateur à celle de l'émission du convertisseur spectral.

Alternativement, les nano-antennes optiques MIM peuvent présenter une forme de plot, par exemple de forme carrée, et être disposées selon deux directions principales. Le composant peut alors comprendre en outre une couche d'encapsulation isolante électriquement et transparente entre les plots et une couche conductrice transparente en contact avec les deuxièmes couches métalliques d'au moins une partie des nano-antennes optiques pour former un contact électrique supérieur pour le premier ensemble de nano-cellules photovoltaïques.

Selon une variante, la couche de conversion spectrale comprend un ou plusieurs matériaux de conversion spectrale insérés dans une matrice solide ou liquide. Les matériaux de conversion spectrale comprennent par exemple des molécules fluorescentes, phosphorescentes ou des boîtes quantiques. La nature de la matrice peut être choisie en fonction de son épaisseur, par exemple des polymères organiques pour des épaisseurs millimétriques ou des résines pour des épaisseurs de l'ordre du micromètre.

Selon une variante, la couche de conversion spectrale comprend au moins deux matériaux de conversion spectrale, le spectre d'absorption du second matériau recouvrant le spectre d'émission effective du premier matériau et le spectre d'émission effective du second matériau étant au moins partiellement superposé avec ladite première bande spectrale de résonance. Un tel arrangement de matériaux de conversion spectrale permet un fonctionnement « en cascade » du composant photovoltaïque, permettant avec un seul type de nano-antennes optiques d'absorber des photons issus d'une plage plus étendue du spectre solaire.

Selon une variante, le composant photovoltaïque comprend au moins un premier ensemble de nano-cellules photovoltaïques comprenant chacune une nano-antenne optique présentant une première bande spectrale de résonance et un deuxième ensemble de nano-cellules photovoltaïques comprenant chacune une nano-antenne optique présentant une deuxième bande spectrale de résonance.

Dans ce cas, la couche de conversion spectrale peut comprendre un matériau de conversion spectrale permettant la conversion d'au moins une partie du spectre solaire vers les première et deuxième bandes spectrales de résonance. Autrement dit, deux types de nano-antennes photovoltaïques sont utilisés pour absorber les photons émis par un matériau de conversion spectrale, permettant une meilleure absorption de toute la bande spectrale d'émission du matériau de conversion spectrale.

Alternativement, la couche de conversion spectrale comprend au moins deux matériaux de conversion spectrale, chacun desdits matériaux de conversion spectrale permettant la conversion d'au moins une partie du spectre solaire vers chacune desdites première et deuxième bandes spectrales de résonance. On parle alors d'une mode « en parallèle » du composant photovoltaïque, qui permet également d'élargir la plage du spectre solaire utile pour le dispositif photovoltaïque.

Selon une variante, le composant photovoltaïque comprend en outre un ensemble de nano-cellules photovoltaïques comprenant chacune une nano-antenne optique dont la bande spectrale de résonance est adaptée à l'absorption directe d'une partie du spectre solaire.

Selon un deuxième aspect, l'invention concerne une méthode de fabrication d'un composant photovoltaïque selon le premier aspect comprenant :
- Le dépôt sur un substrat métallisé d'un empilement de couches en matériau semi-conducteur dont une couche absorbante dans ladite première bande spectrale de résonance;
- Le dépôt d'une couche métallique structurée ;
- La gravure auto-alignée d'au moins une partie desdites couches en matériau semi-conducteur;
- Le dépôt d'une couche d'encapsulation et d'une couche de contact supérieur en matériau conducteur transparent.

Selon une variante, l'étape de dépôt comprend la réalisation par épitaxie sur un substrat adapté dudit empilement de couches en matériau semi-conducteur et le report desdites couches en matériau semi-conducteur sur le substrat métallisé.

### BREVE DESCRIPTION DES DESSINS

D'autres avantages et caractéristiques de l'invention apparaîtront à la lecture de la description, illustrée par les figures suivantes :
- Figure 1, un schéma illustrant le principe d'un exemple de composant photovoltaïque selon l'invention ;
- Figure 2, une courbe montrant le spectre solaire sur laquelle sont indiquées des exemples de bandes spectrales d'absorption et d'émission d'un matériau de conversion spectrale et la bande spectrale d'absorption d'un résonateur électromagnétique adaptée au spectre d'émission du matériau de conversion spectrale;
- Figure 3, un schéma illustrant une nano-cellule photovoltaïque comprenant une nano-antenne optique de type MIM ;
- Figure 4, les courbes montrant les spectres d'absorption et d'émission d'un exemple de matériau de conversion spectrale pour la couche de conversion spectrale ;
- Figures 5A à 5G, des schémas illustrant un procédé de fabrication d'un composant photovoltaïque, selon un exemple de réalisation;
- Figures 6A et 6B, des schémas illustrant les pertes d'énergie lumineuse utile, respectivement dans un système de l'art antérieur et dans un système selon la présente description ;
- Figures 7A à 7C des courbes montrant le taux de photons absorbé par les cellules photovoltaïques en fonction respectivement du gain géométrique, du rendement quantique de photoluminescence du colorant, du facteur de qualité des nano-antennes MIM, dans des systèmes de l'art antérieur et selon la présente description ;
- Figure 8, une courbe montrant le spectre solaire sur laquelle sont indiquées des exemples de bandes spectrales d'absorption et d'émission de deux matériaux de conversion spectrale dans un mode « en cascade » ;
- Figures 9A à 9C, des schémas illustrant l'absorption et l'émission de deux matériaux de conversion spectrale en fonction de la longueur d'onde, ainsi que l'absorption d'un résonateur électromagnétique, respectivement dans un mode « en cascade », dans un mode « en parallèle » et dans un mode « mixte »;
- Figure 10, un schéma illustrant un exemple de connexion électrique pour des nano-cellules photovoltaïques fonctionnant avec une couche de conversion spectrale dans un mode parallèle ou mixte.

### DESCRIPTION DETAILLEE

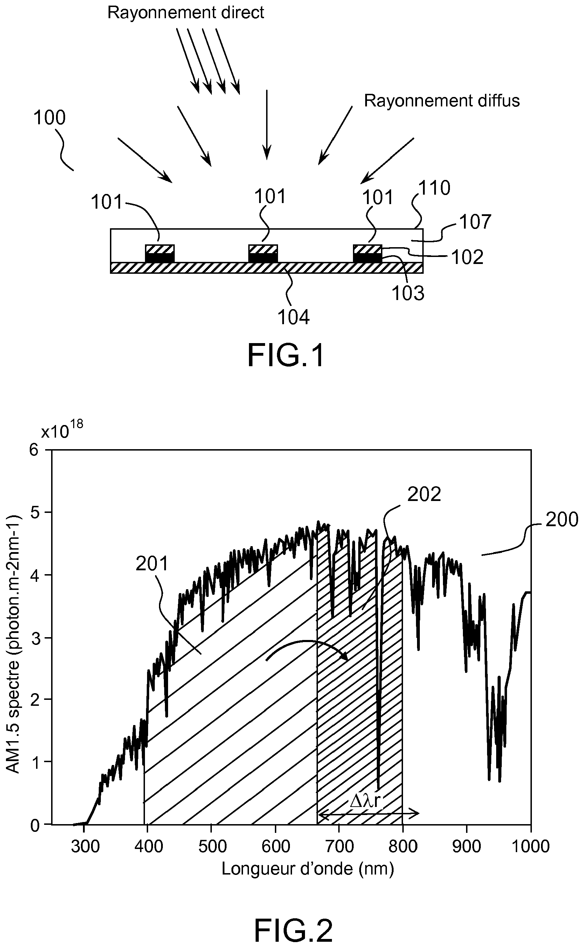

Les figures 1 et 2 illustrent respectivement par un schéma simplifié et par un graphique montrant des bandes spectrales d'absorption/émission superposées au spectre solaire, le principe de l'invention.

Le composant photovoltaïque 100 schématisé sur la figure 1 comprend sur sa face destinée à être exposée au soleil une couche 107 de conversion spectrale de tout ou partie du spectre solaire. La couche 107 comprend un matériau de conversion spectrale, par exemple un colorant luminescent, permettant d'absorber la lumière solaire incidente et de la réémettre de façon isotrope dans une bande spectrale décalée vers les grandes longueurs d'onde et de largeur beaucoup plus faible que celle du rayonnement solaire (typiquement quelques dizaines à une centaine de nanomètres). La couche de conversion spectrale agit donc comme un concentrateur spectral. La concentration spectrale est illustrée sur la figure 2 dont la courbe 200 représente le spectre solaire (spectre solaire AM1.5 tracé en nombre de photons/m²/nm). La zone hachurée 201 illustre la bande d'absorption de la couche 107 de conversion spectrale correspondant à la bande d'absorption d'un matériau de conversion spectrale contenu dans la couche 107, par exemple un colorant, et la zone hachurée 202 illustre la bande d'émission effective de ce matériau sous flux lumineux incident. On observe la concentration spectrale du flux lumineux par le fait que la bande spectrale d'émission est plus étroite que la bande spectrale d'absorption. Elle est par ailleurs décalée vers les plus grandes longueurs d'onde.

Le composant photovoltaïque 100 comprend en outre un ensemble de nano-cellules photovoltaïques 101 recouvertes par la couche de conversion spectrale 107. Chaque nano-cellule photovoltaïque comprend une nano-antenne optique présentant une bande spectrale de résonance Δλᵣ définie notamment par la géométrie de la nano-antenne et un dispositif photovoltaïque. Lorsque la conception de la nano-antenne est optimisée, elle présente une absorption quasi-parfaite à la longueur d'onde de résonance et se comporte comme un miroir en dehors de la bande spectrale de résonance. Des nano-antennes sont décrites de façon générale dans l'article de revue «Nanoantennas for visible and infrared radiation », Reports on Progress in Physics, 75 024402 (2012). Avantageusement, comme cela est illustré sur la figure 1, les nano-antennes optiques sont des résonateurs électromagnétiques de type MIM (métal/isolant/métal) comprenant une première couche métallique 104, un empilement en matériaux semi-conducteur formant une couche diélectrique 103 et une couche métallique 102. Dans cet exemple, la première couche métallique 104 est continue, commune à l'ensemble des structures MIM, et peut former pour l'ensemble des nano-cellules photovoltaïques un premier contact électrique commun. La couche 102 est structurée pour former avec la couche diélectrique 103 et la couche métallique 104 des nano-antennes optiques dont les dimensions sont définies en fonction de la longueur d'onde centrale de résonance souhaitée. La couche métallique structurée 102 contribue à la formation du deuxième contact électrique pour chacune des nano-cellules photovoltaïques. L'empilement en matériau semi-conducteurs, organiques ou inorganiques, formant la couche diélectrique 103 est choisi pour former avec les contacts électriques 102, 104 un dispositif photovoltaïque, permettant la conversion de la puissance lumineuse incidente en puissance électrique.

Les nano-antennes optiques sont avantageusement dimensionnées de façon à obtenir une absorption maximale dans une bande spectrale Δλᵣ qui présente une superposition avec la bande spectrale d'émission (202, figure 2) du matériau de conversion spectrale, de telle sorte à ce que l'ensemble des photons émis par le matériau de conversion spectrale puissent être utilisés par le dispositif photovoltaïque. L'aire effective des nano-antennes étant beaucoup plus petite (facteur supérieur à 10) que leur section efficace d'absorption, chaque nano-antenne se comporte comme un concentrateur spatial. Le couplage des nano-antennes optiques, qui permettent d'assurer la concentration spatiale du flux solaire incident, avec la couche de conversion spectrale assurant la concentration spectrale vers la bande de résonance des nano-antennes, permet d'augmenter considérablement l'efficacité du composant photovoltaïque par rapport aux composants décrits dans l'art antérieur.

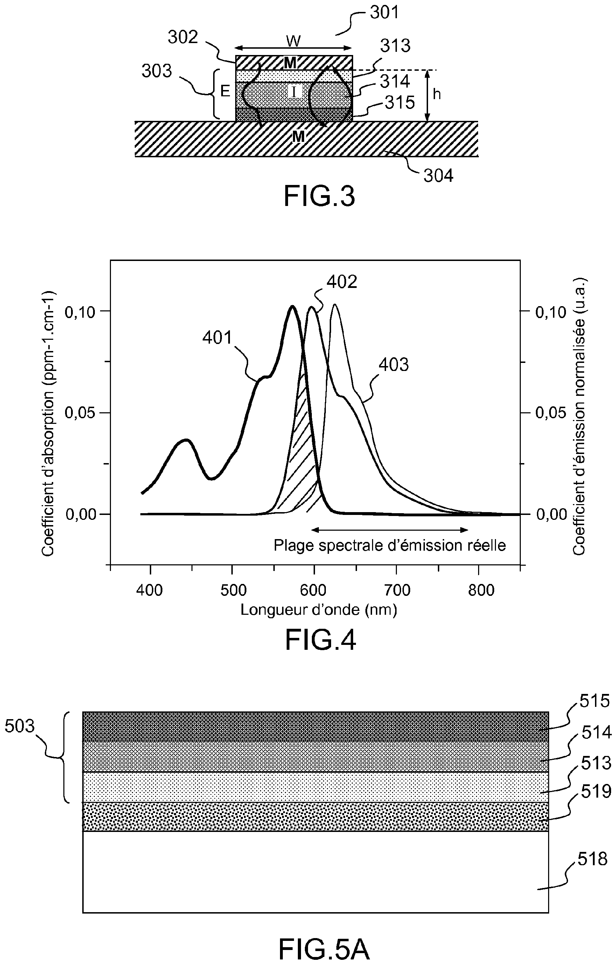

La figure 3 illustre plus en détails un exemple de résonateur 301 de type MIM adapté pour une nano-cellule photovoltaïque d'un composant photovoltaïque selon l'invention.

Comme précédemment expliqué, les résonateurs électromagnétiques, par exemple de type MIM, jouent le rôle de concentrateur spatial de la lumière. L'interférence magnéto-optique de l'onde incidente avec les ondes évanescentes créées par le résonateur permet, à la résonance, par un effet d'entonnoir (F. Pardo et al. « Light funneling mechanism explained by magnetoelectric interference » Phys. Rev. Lett. 107 093902 (2011)), de collecter sur une distance proche de la longueur d'onde tous les photons incidents, pour les concentrer dans le résonateur. Le volume du résonateur peut être aussi petit que λ³/1000 (voir Cattoni et al. précédemment cité), ce qui illustre la capacité de ces nano-antennes à concentrer le flux lumineux incident.

Dans l'exemple de la figure 3, les résonateurs 301 sont formés d'une première couche métallique continue 304 sur laquelle est déposé un empilement structuré formé d'une partie diélectrique 303 (I) et d'une partie métallique 302 (M). La structuration peut être selon une (1D) ou deux (2D) directions, pour former des résonateurs ayant la forme de rubans en 1D ou de plots de forme rectangulaire ou carré en 2D.

Des résonateurs présentant des formes de rubans présentent l'avantage d'être plus faciles à connecter électriquement que des plots. Ils peuvent par ailleurs être agencés pour présenter des résonances dans les deux composantes TE et TM de la polarisation. D'autre part la largeur des rubans pourra, sur une quasi-période inférieure à la longueur d'onde, présenter des variations (marches, biseaux) de façon à élargir sa réponse spectrale et ainsi adapter au mieux la plage d'absorption du résonateur à celle de l'émission du convertisseur spectral.

La cavité ainsi formée présente de façon connue des résonances de type Fabry-Pérot. On distingue deux types de résonances : les modes dits horizontaux (entre deux "miroirs" verticaux formés par les extrémités de la cavité) et les modes dits verticaux (entre les deux "miroirs" horizontaux formés par les couches métalliques). La longueur d'onde de résonance du mode horizontal est déterminée par la largeur W du résonateur (distance entre les miroirs du Fabry-Pérot) et la longueur d'onde de résonance du mode vertical est donnée par l'épaisseur h de la couche diélectrique 103 (distance entre les couches métalliques 102, 104). Dans le cas général on obtient une combinaison de ces modes pour former un mode mixte dit de boîte. Comme pour tout résonateur de type Fabry-Pérot, il existe au moins un arrangement du résonateur, défini notamment par les dimensions latérales et en hauteur de la structure, et par les épaisseurs des couches, qui permet en équilibrant le flux incident et l'absorption interne au résonateur, d'atteindre à la résonance une absorption quasi-totale du flux incident. Le couplage du concentrateur spectral et des nano-antennes optiques donne ainsi la possibilité d'utiliser les nano-antennes optiques dans le mode de fonctionnement d'un résonateur électromagnétique à résonance simple. On obtient ainsi une absorption qui peut être quasiment totale dans la bande spectrale de résonance, à la différence d'un résonateur électromagnétique à résonance multiple, dans lequel la recherche de l'optimisation de l'absorption sur tout le spectre solaire peut se faire au détriment éventuel de celle liée à une résonance particulière.

La partie diélectrique (I) 303 des résonateurs MIM 301 comprend un empilement de couches adapté à la réalisation d'un dispositif photovoltaïque. Les couches métalliques (M) 302, 304 jouent, en plus de leur rôle électromagnétique, celui d'électrodes pour le dispositif photovoltaïque. L'empilement des couches 303 comprend au moins une couche 314 en matériau semi-conducteur absorbant dans la bande spectrale de résonance du résonateur MIM, par exemple la couche non intentionnellement dopée dans une jonction de type PIN. Selon la nature du dispositif photovoltaïque que l'on souhaite réaliser, une ou plusieurs couches additionnelles peuvent être prévues, par exemple des couches en matériau semi-conducteur ou des couches d'interface, qui, avec la couche 314 en matériau absorbant vont contribuer à la fonction photovoltaïque. Dans l'exemple de la figure 3, les couches 313, 315 sont par exemple des couches ou empilements de couches en matériau semi-conducteur fortement dopées, en contact avec les couches métalliques 302, 304 respectivement, et assurant une faible résistance d'accès électrique. Le fort niveau de dopage de ces couches réduit d'une part leur résistivité électrique et d'autre part la résistance spécifique du contact. Ces couches pourront être choisies en matériau semi-conducteur transparent pour optimiser la collection des photo-porteurs. Les nano-antennes sont conçues de façon à concentrer le champ électrique dans la partie diélectrique 303 des résonateurs MIM, de telle sorte à minimiser le champ électrique dans les parties métalliques, et à minimiser par conséquent les pertes par absorption.

Dans l'exemple des la figure 3, l'ensemble des couches en matériau semi-conducteur formant la partie diélectrique I est structurée de façon similaire à la couche métallique 302. Alternativement, il est possible de ne structurer que la couche ou l'empilement de couches en matériau semi-conducteur dopé 313 qui forme le contact électrique avec la couche métallique 302.

Selon une variante, parmi les différentes modes optiques possibles du résonateur MIM, on peut privilégier ceux permettant de réduire au mieux l'aire de la jonction pour maximiser le facteur de concentration du flux incident. En effet la section efficace (aire de collection des photons incidents) d'une nano-antenne carrée étant approximativement λ², le rapport de concentration pour une nano-antenne carrée de dimension W est égal à (λ/W) ². Par exemple, on pourra utiliser des résonateurs MIM à mode vertical, la hauteur h de l'empilement diélectrique 303 étant fixée à h= λ₀/2n_{eff}, où λ₀ est la longueur d'onde centrale de résonance recherchée et n_{eff} est l'indice effectif du mode dans le résonateur, proche de l'indice de réfraction de l'empilement diélectrique. La largeur W du résonateur MIM, mesuré sur la partie métallique structurée (302), peut être alors fixée à sa plus faible valeur de façon à conserver le mode vertical et réduire les courants d'obscurité proportionnels à la surface de la jonction. Typiquement, on pourra choisir W inférieur ou égal à λ₀/5, par exemple de l'ordre de λ₀/5. Dans le cas particulier d'un dispositif photovoltaïque de type jonction PN, en GaAs (arséniure de gallium) par exemple, de longueur d'onde de fonctionnement à 0,9 µm et d'indice de réfraction 3,5, la hauteur totale h de l'empilement diélectrique 303 est d'environ 140 nm pour un fonctionnement optimal. La longueur d'onde de fonctionnement est définie ici comme la longueur d'onde à laquelle on observe un pic d'absorption en tenant compte à la fois de la bande spectrale de résonance liée à la géométrie de la nano-antenne et au spectre d'absorption du matériau semi-conducteur absorbant des nano-cellules photovoltaïques. Cette épaisseur représente une réduction d'environ un facteur 10 par rapport aux meilleures cellules photovoltaïques à base de GaAs connues dans la littérature, telles que décrites par exemple dans G.J Bauhuis et al «26.1% thin-film GaAs solar cell using epitaxial lift-off » Solar Energy & Solar Cells 93 1488 (2009).

La réduction d'épaisseur de l'empilement diélectrique présente deux types d'avantages par rapport aux cellules photovoltaïques classiques, telles que définies par exemple dans la référence précédemment citée. Tout d'abord des améliorations sur le fonctionnement de la cellule donc sur ses performances. En effet, la réduction de l'épaisseur des couches semi-conductrices se traduit par une réduction du temps de transit moyen des photo-porteurs. Il en résulte une réduction de leur probabilité de recombinaison donc une augmentation du rendement de conversion de la cellule. La conjonction d'une faible épaisseur de matériau semi-conducteur et la présence d'électrodes métalliques en contact direct avec la zone active réduit également de façon drastique les résistances d'accès électriques, ce qui permet, par un fonctionnement de la cellule sous forte concentration, d'augmenter son rendement de conversion. Par ailleurs, la réduction d'épaisseur des couches de semi-conducteur associée à leur structuration latérale conduit à une réduction drastique du volume de semi-conducteur utilisé par rapport à une cellule standard (un facteur compris entre 100 et 1000). Cette réduction se traduit par une double réduction du coût des cellules : moins de matériau à fournir et des temps de fabrication réduits. Cet avantage pourrait s'avérer décisif pour les semi-conducteurs réalisés à partir d'éléments rares sur terre, comme l'indium dans le système CIGS et le tellure dans le tellurure de cadmium (CdTe).

Le rôle de la couche de conversion spectrale (107, figure 1) est d'une part d'absorber la lumière solaire sur une large bande spectrale, idéalement aussi large que le spectre solaire, et d'autre part de réémettre cette lumière dans un spectre étroit, de telle sorte à ce que le spectre d'absorption des nano-antennes optiques telles que décrites précédemment puisse se superposer au mieux au spectre d'émission.

Il existe différents types de matériaux adaptés à la réalisation de la couche de conversion spectrale. A titre d'exemple, on peut citer les molécules fluorescentes (rhodamine 6G, Lumogen RED 305® commercialisé par BASF®), phosphorescentes (SrB407 dopé Sm2+, et d'une manière générale dopé RE2+, où RE désigne les terre-rares) ou encore des boîtes quantiques, c'est-à-dire des structures de type coeur/coquille où les états électroniques du coeur sont confinés par la barrière de potentiel de la coquille, telles que décrites par exemple dans B.O. Dabbousi et al « (CdSe)ZnS core-shell quantum dots: synthesis and characterization of a size series of hyghly luminescent nanocrystallites » J. Phys. Chem B. 101(46) 9463 (1997), ou Liang Li et al. « Highly luminescent CuInS2/ZnS core/shell nanocrystals : cadium-free quantum dots for in vivo imaging » Chem. Matter. 21(12) 2422 (2009)).

La figure 4 donne un exemple de spectres d'absorption et d'émission d'un convertisseur spectral utilisant un colorant Lumogen RED 305® de chez BASF®. Sur cette figure sont représentées la courbe d'absorption 401 du colorant, la courbe 402 d'émission de fluorescence et la courbe d'émission effective 403 qui est aussi la plage d'émission réelle du colorant car elle prend en compte l'auto-absorption des photons émis par le colorant.

En pratique, on cherche pour la couche de conversion spectrale un matériau présentant une plage d'absorption la plus large possible (typiquement de 400 nm jusqu'à la longueur d'onde d'émission la plus basse) associé à un spectre d'émission étroit qui coïncide avec la résonance des nano-antennes optiques. En limitant les pertes par recombinaison non radiative au sein du matériau de conversion spectrale, on atteint avantageusement un rendement de luminescence (rapport du nombre de photons émis sur le nombre de photons absorbés) du matériau de conversion proche de 100%. Enfin, on cherche un matériau de conversion spectrale présentant une région spectrale de recouvrement (région de longueurs d'onde pour lesquelles le convertisseur peut à la fois émettre et absorber, représentée par la zone hachurée sur la figure 4) étroite pour limiter le phénomène d'auto-absorption, qui multiplie les pertes par désexcitation non radiative.

Le matériau assurant la conversion spectrale (« convertisseur spectral ») est par exemple inséré dans une matrice (liquide ou solide) pour former la couche de conversion spectrale 107 (figure 1). La matrice est transparente sur toute la plage de longueur d'onde correspondant à l'absorption et l'émission du convertisseur spectral. Par ailleurs, elle est choisie de telle sorte à permettre une dispersion homogène du matériau afin d'éviter les agrégats qui dégradent les performances optiques des éléments qui les composent, et à ne pas modifier les propriétés optiques des convertisseurs. Notamment, la matrice est choisie pour limiter l'introduction de procédés de relaxation qui conduiraient à de faibles durées de vie non-radiatives. De nombreux matériaux possibles existent pour la matrice et dépendent, outre les conditions susmentionnées, de la nature du convertisseur spectral, ainsi que de l'épaisseur et de l'indice optique souhaités pour la couche de conversion spectrale.

L'épaisseur optimale de la couche de conversion spectrale dépend directement de la concentration en colorant. Ces deux paramètres, épaisseur et concentration, conditionnent le libre parcours moyen des photons dans la couche de conversion spectrale. Un optimum est avantageusement trouvé quand la grande majorité des photons est absorbée par le colorant en maintenant à un faible niveau les pertes dues à la concentration (désexcitation non-radiative et formation d'agrégats) et à la réflexion sur le plan inférieur du concentrateur (les nano-antennes sont réfléchissantes aux longueurs d'onde en dehors de la résonance). Pour des épaisseurs de l'ordre du micromètre, un exemple de matériau pour la matrice peut être une résine de type EPON™ SU-8 (HEXION™) ou du ZnO nanostructuré. Pour des épaisseurs millimétriques, des polymères organiques peuvent être utilisés et déposés par moulage (PMMA (polyméthacrylate de méthyle), PDMS (polydiméthylsiloxane), polyuréthane, éthylène-acétate de vinyle (EVA) par exemple) ainsi que des matrices non organiques (ZnO (oxyde de zinc), SnO2 (oxyde d'étain), Al2O3 (oxyde d'aluminium), etc.).

Les figures 5A à 5G illustrent un exemple de réalisation pour la fabrication d'un composant photovoltaïque selon la présente description, adaptées par exemple à des couches en matériau semi-conducteur monocristallin.

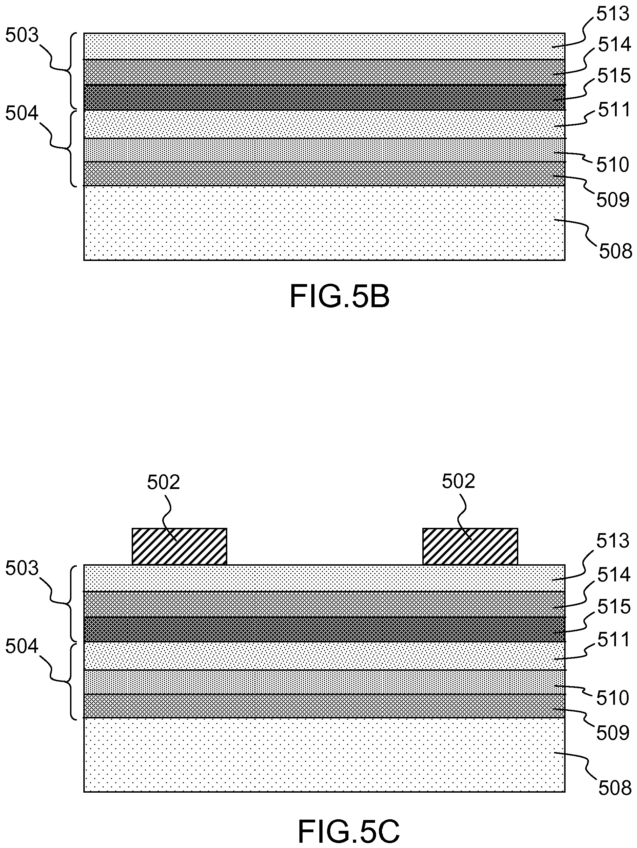

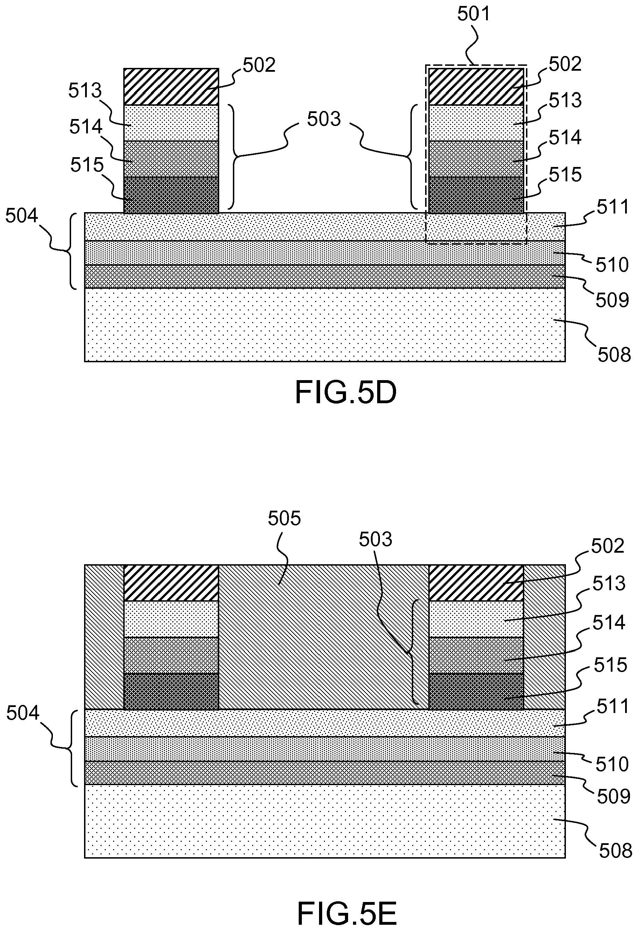

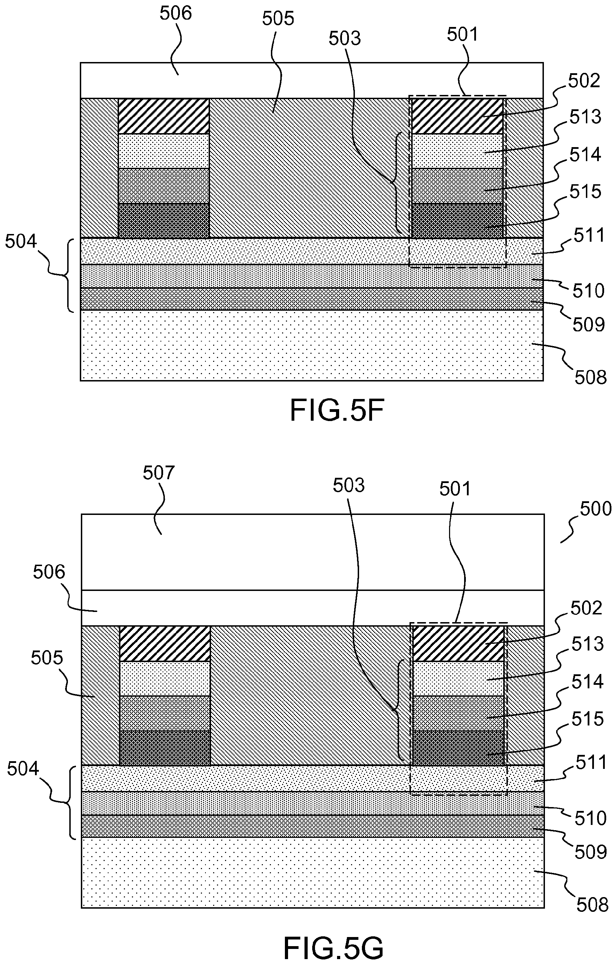

Dans une première étape (figure 5A), on réalise par épitaxie sur un substrat 518 adapté (par exemple en InP) un empilement 503 de couches 513, 514, 515 en matériau semi-conducteur (par exemple en InP). Une couche d'arrêt 519 (par exemple en InGaAs) est également épitaxiée entre le substrat et l'empilement 503. Les couches 513, 514, 515 sont adaptées à la réalisation du dispositif photovoltaïque recherché. Par exemple, il s'agit respectivement de couches en InP dopée n, intrinsèque et dopée p pour former une jonction PIN. Dans une deuxième étape (figure 5B), il est procédé au report de l'empilement 503 sur un substrat hôte 508 (par exemple en Pyrex®). Cette opération est réalisée en deux temps. Tout d'abord un collage anodique entre le Pyrex® et les couches métalliques (empilement 504 de couches métalliques 509, 510, 511, par exemple respectivement en aluminium, titane, or) déposées sur la couche 515, puis retrait du substrat 518 par gravure chimique sélective de celui-ci par rapport à la couche d'arrêt 519. La couche d'arrêt 519 est ensuite gravée sélectivement par rapport à la couche active 513. Dans une troisième étape (figure 5C), il est procédé au dépôt d'une couche métallique structurée 502, par exemple en or, par lithographie puis lift-off ou par nano-impression. Dans une quatrième étape (figure 5D), il est procédé à une gravure auto-alignée de l'empilement des couches semi-conductrices 503, permettant de former les plots 501. Selon une variante, cette gravure peut ne pas être complète et laisser intacte tout ou parties de l'empilement de couches 514 et 515. Dans une cinquième étape (figure 5E), il est procédé après une éventuelle passivation des flancs de gravure, au dépôt d'une couche 505 d'encapsulation, isolante et transparente (par exemple ZnO), puis au dépôt d'une couche de contact supérieur 506 en matériau conducteur transparent, par exemple en ZnO dopé aluminium (figure 5F), en contact électrique avec les plots métalliques 502. Enfin, la couche de conversion spectrale 507 est déposée sur le dessus de la structure (figure 5G), formant la face avant du composant photovoltaïque 500, destinée à recevoir le flux solaire incident.

Les couches en matériau semi-conducteur mono cristallin épitaxiées puis reportées telles que décrites dans le procédé ci-dessus peuvent comprendre par exemple des couches en arséniure de gallium (GaAs) et les alliages associés (par exemple l'arséniure d'aluminium et de gallium AlGaAs), des couches en phosphure d'indium InP et les alliages associés (par exemple l' arséniure de gallium et d'indium InGaAs), des couches en antimoniure de gallium (GaSb) et les alliages associés (par exemple l'antimoniure de gallium et d'aluminium AlGaSb), des couches en silicium (Si).

Selon une variante, il est possible de déposer les couches en matériau semi-conducteur localement, par plasma, évaporation ou électrodéposition. Les couches en matériau semi-conducteur qui peuvent être déposés localement sont par exemple les couches en alliage cuivre indium gallium sélénium (CIGS) ou cuivre zinc étain souffre CZTS (par co-évaporation ou électrodéposition), et les couches en silicium (Si amorphe, micro cristallin ou polycristallin) qui peuvent être déposés par plasma. Dans ce cas, un procédé de fabrication d'un composant photovoltaïque selon l'invention peut comprendre le dépôt (plasma, évaporation, électrodéposition...) sur substrat métallisé de l'empilement des couches en matériau conducteur adapté pour former le dispositif photovoltaïque recherché, le dépôt d'une couche métallique structurée (lithographie puis lift-off), la gravure auto-alignée de la couche en matériau semi-conducteur, le dépôt d'une couche d'encapsulation isolante et transparente, le dépôt d'une couche de contact supérieur en matériau conducteur transparent, par exemple en ZnO.

Dans le cas de couches en matériau semi-conducteurs organiques (par exemple poly(3-hexylthiophène) (P3HT) et [6,6]-phényl-C61-buanoate de méthyle (PCBM)) ou hybrides (par exemple CdSe et P3HT), un procédé similaire à celui décrit en référence aux couches en matériau semi-conducteur polycristallin peut être réalisé, mais le dépôt pourra être fait à la tournette (spin coating) ou au moyen d'un doctor blade®

Dans les exemples de procédés de fabrication décrits ci-dessus, il est toujours possible de récupérer lors de la gravure de la couche en matériau semi-conducteur, les matériaux à coût de revient élevé.

Les exemples décrits précédemment ont été limités par souci de clarté de l'exposé, à l'association d'un seul convertisseur spectral et d'un seul ensemble de nano-cellules semblables. Cette démarche peut être généralisée à l'association de un ou plusieurs colorants avec une ou plusieurs types de nano-cellules, comme cela sera décrit plus en détails par la suite.

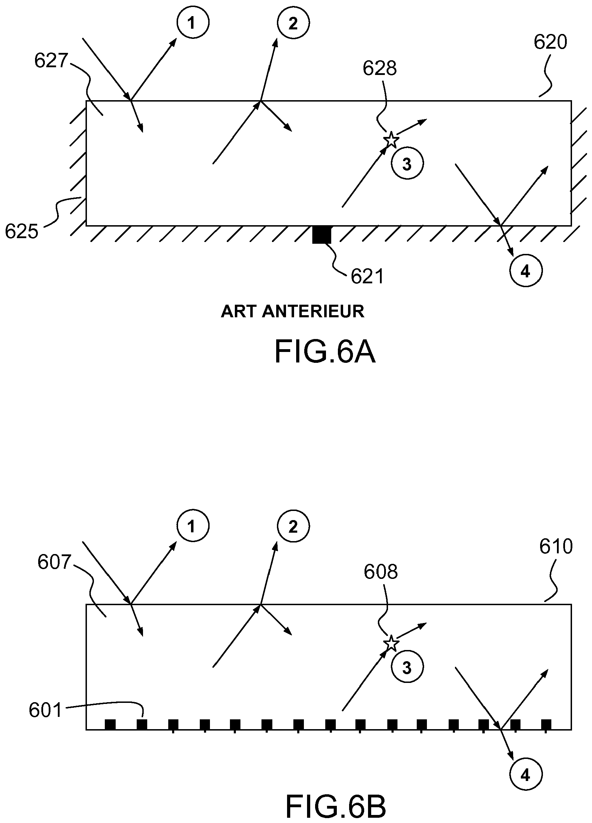

Afin d'illustrer l'avantage procuré par un composant photovoltaïque du type de celui présenté dans la présente description, des simulations Monte Carlo de performances ont été effectuées sur trois systèmes. Les deux premiers systèmes sont des systèmes décrits dans l'art antérieur et sont schématisés sur la figure 6A, le 3^{ème} système est un exemple de composant photovoltaïque conforme à la présente description et est schématisé sur la figure 6B.

Le premier système, représenté sur la figure 6A, est de type LSC standard (selon l'abréviation de l'expression anglo-saxonne « Luminescent solar concentrator »). Il comprend une couche 627 en polymère organique contenant des molécules fluorescentes 628. La face avant 620 est la face destinée à recevoir le flux solaire incident. Un réflecteur en argent 625 est agencé en face arrière (face opposée à la face de réception du flux solaire incident). Une cellule photovoltaïque 621 est insérée dans ce réflecteur dont elle couvre une faible partie. Elle définit ainsi la concentration géométrique du système : rapport de l'aire éclairée par le flux incident à celle de la cellule.

Le second système considéré est comparable au premier système mais comprend un filtre (dit PBS pour « Photonic Band-stop ») agencé en face avant (non représenté sur la figure 6A). Le filtre PBS est ici simulé par une réflexion totale (R=l) pour les longueurs d'onde supérieures à 620 nm et une transmission parfaite (T = 1) en dessous de cette longueur d'onde. La longueur d'onde de coupure de 620 nm est la valeur pour laquelle le nombre de photons (i.e. de longueur d'onde inférieure à 620 nm) absorbés par la cellule photovoltaïque est maximal.

Le troisième système (figure 6B) est un exemple de composant photovoltaïque conforme à la présente description. Il comprend un ensemble de nano-cellules photovoltaïques 601 agencées en face arrière d'une couche de conversion spectrale 607 comprenant un matériau 608 de conversion spectrale, permettant la conversion d'au moins une partie du spectre solaire vers la bande spectrale de résonance des nano-antennes optiques présentes dans chacune des nano-cellules. La face avant destinée à recevoir le flux solaire incident est référencée 610.

Pour faciliter la comparaison, les paramètres ont été conservés d'un système à l'autre, à chaque fois qu'il était possible de le faire. Ainsi, pour les simulations, les hypothèses suivantes ont été considérées. Les trois systèmes présentent une couche en polymère organique (607, 627) d'indice optique 1,75 et d'épaisseur 5 mm. La couche de polymère contient des molécules fluorescentes du colorant Lumogen RED 305® dont les spectres d'absorption et d'émission sont montrés sur figure 4. La concentration est fixée à 270 ppm (parties par million) ; elle est comparable à celle rapportée dans la littérature, ce qui correspond à une absorption quasi-totale (99%) sur un aller-retour dans cette couche des photons présentant dans la gamme spectrale d'absorption, la probabilité d'absorption la plus faible (i.e. 470 nm, voir figure 4). Le rendement de luminescence ou PLQY selon l'abréviation de l'expression anglo-saxonne « photo luminescence quantum yield » est fixé à 0,95. Il correspond à la valeur minimale garantie par le fabricant. Les cellules photovoltaïques sont réalisées avec un matériau semi-conducteur présentant une énergie de bande interdite Eg=1,77 eV, soit une longueur d'onde de coupure de 700 nm.

Les deux premiers systèmes présentent par ailleurs, en face arrière, un miroir de réflectivité R=0,98 et une cellule couvrant 2% de l'aire d'entrée du système, soit une concentration géométrique de 50.

Le troisième système correspondant au composant photovoltaïque selon la présente description présente en face arrière un assemblage de nano-cellules photovoltaïques tel qu'à la résonance la face arrière se comporte comme une surface parfaitement absorbante. Le spectre d'absorption des nano-cellules est simulé par une Lorentzienne centrée à 665 nm et de largeur totale à mi-hauteur FWHM=133 nm, soit un facteur de qualité Q=5. Les pertes par absorption dans le métal sont fixées égales à 5% de l'absorption totale. La somme des aires de ces nano-cellules est égale à 2% de l'aire d'entrée du système, soit une concentration géométrique de 50 égale à celle des deux premiers systèmes.

Le tableau 1 ci-dessous présente la répartition des pertes calculées pour les trois systèmes étudiés ainsi que le taux de photons absorbés par les cellules. On distingue dans ce tableau les différentes causes de pertes, schématisées sur les figures 6A et 6B par les chiffres 1 à 4. Les « pertes en entrée » (notées 1) sont les pertes de Fresnel liées à la réflexion des photons incidents sur le dioptre air/PMMA d'entrée du système. Les « pertes en face-avant » (notées 2) sont les pertes liées à la transmission à travers le dioptre PMMA/air de la face-avant des photons dans la couche de conversion spectrale. Les « pertes non-radiatives » (notées 3) sont les pertes liées à la relaxation non-radiative de l'excitation du colorant (i.e. écart au rendement quantique idéal de luminescence du colorant). Les « pertes en face-arrière » (notées 4) sont les pertes de photons en face arrière dues à l'absorption dans le métal : celui du miroir non-idéal (R=0,98) dans les deux premiers systèmes et celui des nano-résonateurs MIM (5% de l'absorption totale) dans le cas du troisième système. Les « photons (lambda>700nm) » sont les pertes dues à une émission par le colorant de photons de trop basse énergie pour être absorbés par le matériau semi-conducteur absorbant des cellules photovoltaïques.

Le tableau 1 présente également le « taux de photons absorbés » par la cellule photovoltaïque 621 dans le cas des deux premiers systèmes et par l'ensemble des nano-cellules 601 dans le cas du composant photovoltaïque selon la présente description.

**Tableau 1 : Répartition des pertes calculées pour les trois systèmes étudiés et du taux de photons absorbés par le dispositif photovoltaïque.**

| | Pertes en entrée | Pertes en face-avant | Pertes non-radiatives | Pertes en face-arrière | Taux de photons absorbés | Photons (lambda > 700nm) |
|---|---|---|---|---|---|---|
| Système 1 LSC classique sans PBS | 7.4 % | 48,4 % | 12,8 % | 15.4 % | 13.5 % | 2,8 % |
| Système 2 LSC classique avec PBS | 36,9 % | 7,1 % | 13,9 % | 20,9 % | 19,0 % | 2,2 % |
| Système 3 Composant PV selon l'invention | 7.4 % | 11,5 % | 7,3 % | 3,7% | 66,9 % | 3,2 % |

L'indice optique (n=1,75) choisi pour le polymère correspond au meilleur compromis dans la conception du dioptre air/polymère pour le piégeage des photons dans la couche de conversion spectrale principalement constituée de ce polymère. En effet les « pertes en entrées » sont d'autant plus élevées que l'indice est fort alors que les « pertes en face-avant » sont d'autant plus élevées que l'indice est faible. On notera cependant que cet optimum n'est pas très marqué et que l'utilisation d'un polymère classique comme le PMMA (n=1.49) introduit une perte supplémentaire inférieure à 1%.

La limitation principale (48,4%) du système LSC sans PBS (système 1) est due aux « pertes en face-avant », causées par la réflexion incomplète sur ce dioptre des photons dans la couche de conversion spectrale. En effet cette réflexion est totale (réflexion totale interne) lorsque l'angle d'incidence est supérieur à l'angle limite (ici 36 degrés) mais très faible (en moyenne inférieure à 10%) en deçà. Les photons présentant une distribution isotrope après leur émission par le colorant, subissent donc une forte perte (P=15%) lors de la réflexion suivant l'émission par le colorant. Les réflexions suivantes jusqu'à la prochaine absorption-émission par le colorant, seront totales puisque tous les photons ont des angles supérieurs à l'angle critique (tri réalisé par la première réflexion). D'autre part, la cellule ne couvrant que 2% de la face avant (concentration géométrique égale à 50), les photons doivent effectuer de nombreux d'allers-retours entre les faces avant et arrière de la couche de conversion spectrale, avant d'être absorbés par le semi-conducteur ou perdus dans un des processus du tableau 1. La simulation a dénombré, pour chaque photon collecté par le semi-conducteur, une moyenne de 18,5 réflexions sur chacune des deux faces et 3,8 absorptions par le colorant. Une perte P=15% à chaque première réflexion donne une probabilité de perte par la face avant de 1-(1-P)³_{'}⁸ = 46% en bon accord avec les résultats de la simulation.

Pour réduire l'effet de cette limitation, l'introduction d'un filtre PBS en face avant (système 2) peut permettre de laisser passer les photons de faible longueur d'onde (majoritairement des photons incidents) et de réfléchir ceux de plus grande longueur d'onde (majoritairement des photons émis par le colorant). On espère ainsi jouer avec le décalage spectral entre absorption et émission pour améliorer le piégeage des photons dans la couche de conversion. Les résultats de la simulation montrent une amélioration certaine du taux de photons absorbés par le semi-conducteur (19% au lieu de 13,5% dans le système précédent) mais dans une proportion trop faible pour fournir un système efficace. L'effet limité du filtre PBS est principalement dû à deux effets : d'une part, le rejet des photons incidents de longueur d'onde trop grande (36,9% de perte sur la face d'entrée) et d'autre part, le trop d'allers-retours dans la cavité augmentant les pertes intrinsèques (20,9% sur le miroir de la face arrière, 14% dans le colorant). En effet la simulation a dénombré une moyenne de 21,6 réflexions sur chacune des deux faces (au lieu de 18,5 dans le système 1) et 4,5 absorptions par le colorant (au lieu de 3,8 pour le système 1).

Ainsi le premier système (LSC sans PBS) est peu efficace parce que ne piégeant pas assez bien les photons dans la couche de conversion, ils s'échappent (pertes en face avant) avant d'être absorbés par le semi-conducteur. Le second système (LSC avec PBS) présente une amélioration du piégeage mais ses performances sont limitées par les pertes intrinsèques aux éléments du système (filtre, miroir, absorption) qu'un meilleur piégeage augmente.

Le système selon la présente invention présente des performances grandement améliorées par rapport aux systèmes de l'art antérieur car les nano-cellules rendent compatible une forte concentration géométrique (ici 50) avec une absorption quasi-parfaite des photons émis par le colorant. Il en résulte une augmentation drastique du taux de photons absorbés par le semi-conducteur (66,9%). Il en résulte également une forte diminution du nombre d'allers-retours des photons entre les deux faces du système. En effet la simulation a dénombré une moyenne de 0,6 réflexion en face avant, 0,3 en face arrière et 1,8 absorptions par le colorant, expliquant les plus faibles pertes en face avant (1-0,85^{0,6}=9,3% proche des 11,7% du tableau 1), en face arrière (5% des absorptions, soit 3,1% proche des 3,3% du tableau 1) et au cours des absorptions-émissions (1-PLQY^{1,8}=8,8% proche des 8,4% du tableau 1).

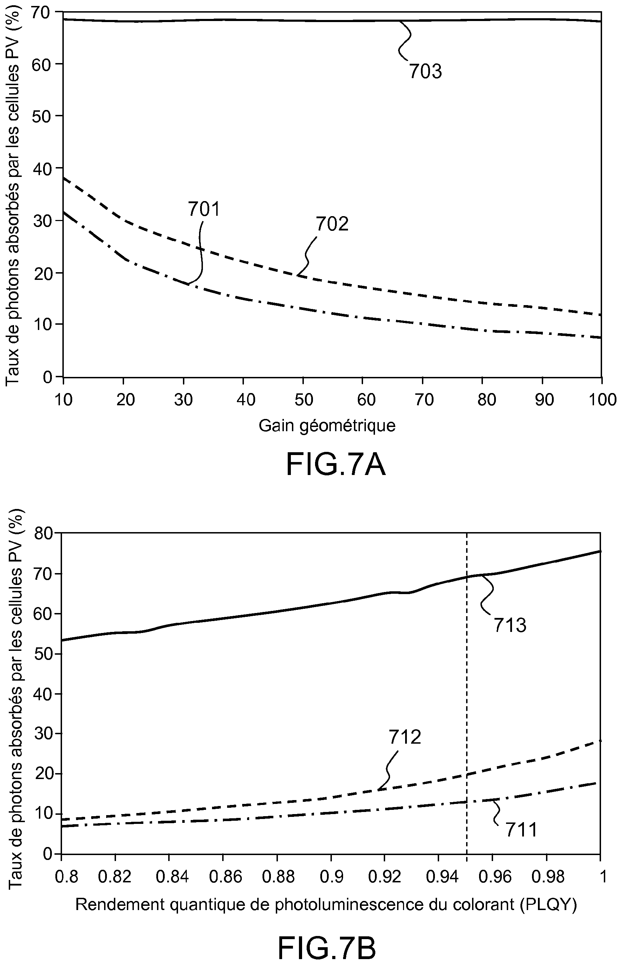

Le composant photovoltaïque selon la présente description permet ainsi d'accéder à de très fortes valeurs de concentration géométrique. En effet la concentration géométrique est, pour une nano-cellule, le rapport de sa section efficace de capture (typiquement λ²) à la section physique de la nano-diode. On peut donc envisager des concentrations géométriques de l'ordre de 100. Avantageusement, les nano-cellules peuvent être disposées sur la face arrière du concentrateur de façon à ce que leurs sections efficaces de capture pavent complètement cette face arrière. À la résonance la face arrière présente donc une absorption quasi-parfaite (i.e. proche de 100%). Il en résulte, comme cela apparait sur la figure 7A, que l'efficacité de collection des photons par les nano-cellules ne dépend pas de la concentration géométrique (courbe 703). Ce n'est pas du tout le cas des systèmes de l'art antérieur (courbes 701 et 702) pour lesquels augmenter la concentration géométrique augmente le nombre d'allers-retours des photons dans la couche de conversion ce qui, comme cela a été montré ci-dessus, augmente les pertes et réduit le taux de photons absorbés par le semi-conducteur.

D'autre part la réduction du nombre d'absorptions par le colorant conduit à une plus faible dépendance des performances du système (i.e. le taux de photons absorbés par le semi-conducteur) au rendement de luminescence du colorant qu'elles ne le sont dans les systèmes de l'art antérieur. Pour illustrer cet effet, le taux de photons absorbés par dispositif photovoltaïque est représenté sur la figure 7B en fonction du rendement de luminescence (PLQY) du colorant. On constate qu'utiliser un colorant de rendement PLQY=0.95 conduit à une réduction relative du taux de photons absorbés par rapport au cas idéal (PLQY = 1), de 21,6% pour le système LSC sans PBS (courbe 711), de 22,7% pour le système avec PBS (courbe 712) et seulement de 9,1% dans le cas de l'invention (courbe 713). Cette plus faible dépendance introduit une plus grande souplesse dans la conception du système de l'invention où on pourra, par exemple, préférer un colorant pour l'adaptation de sa réponse spectrale, au détriment de son rendement de luminescence.

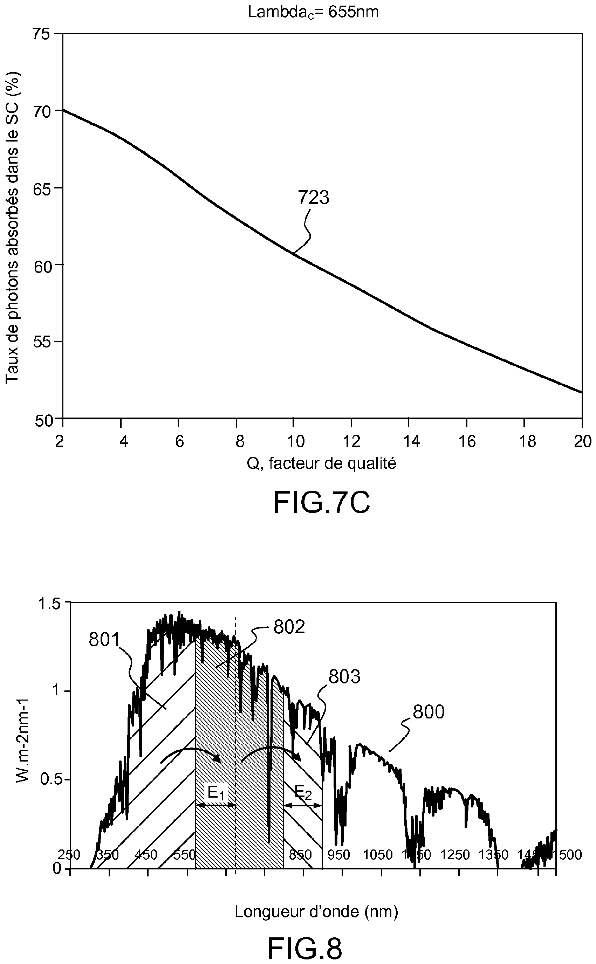

Le caractère résonant de l'absorption des nano-cellules impose d'une part un bon accord entre cette résonance et l'émission du colorant et d'autre part que la résonance soit assez large pour absorber de façon efficace les photons émis par le colorant. Le premier point est facilement résolu en cherchant la longueur d'onde de résonance donnant le maximum de photons absorbés par le semi-conducteur. C'est ce qui a permis dans l'exemple montré ci-dessus de placer la résonance à λ=665 nm. Pour évaluer l'effet du deuxième point (largeur de la résonance) le taux de photons absorbés dans le semi-conducteur est tracé (figure 7C) en fonction du facteur de qualité Q des nano-résonateurs. On constate que le taux de photons absorbés est d'autant plus grand que le facteur de qualité est faible, c'est à dire que le pic de résonance est large. Des taux d'absorption élevés pourront donc être obtenus avec des résonateurs de faible facteur de qualité, l'exemple ci-dessus Q=5. On pourra également juxtaposer dans la même période du pavage des nano-antennes, plusieurs cellules légèrement décalés en longueur d'onde de façon à obtenir une largeur spectrale adaptée à l'émission du colorant choisi.

Les exemples ci-dessous décrivent ainsi différents exemples de réalisation du composant photovoltaïque selon l'invention associant différents types de matériaux de conversion photovoltaïque et/ou différents types de nano-antennes optiques.

Plus précisément, la couche de conversion spectrale peut comprendre plusieurs types de matériaux absorbants/émetteurs (colorants, boites quantiques...) afin de mieux couvrir l'ensemble du spectre solaire. Différentes approches sont alors possibles, appelées dans la suite de la description « mode en cascade », qui met en oeuvre N colorants et un type de nano-cellule, « mode en parallèle » qui met en oeuvre N colorants et N types de nano-cellule et « mode mixte ».

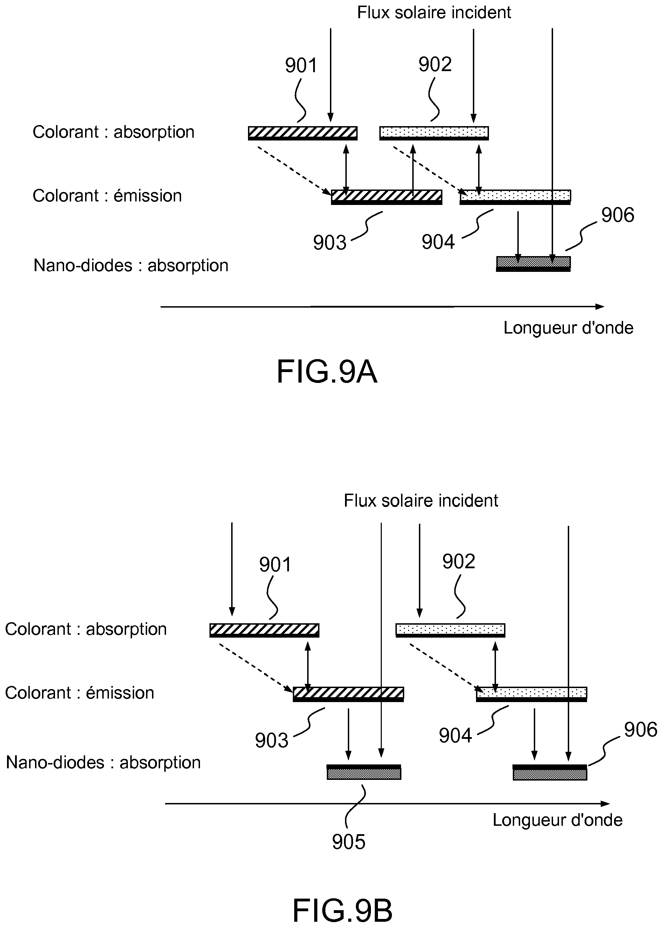

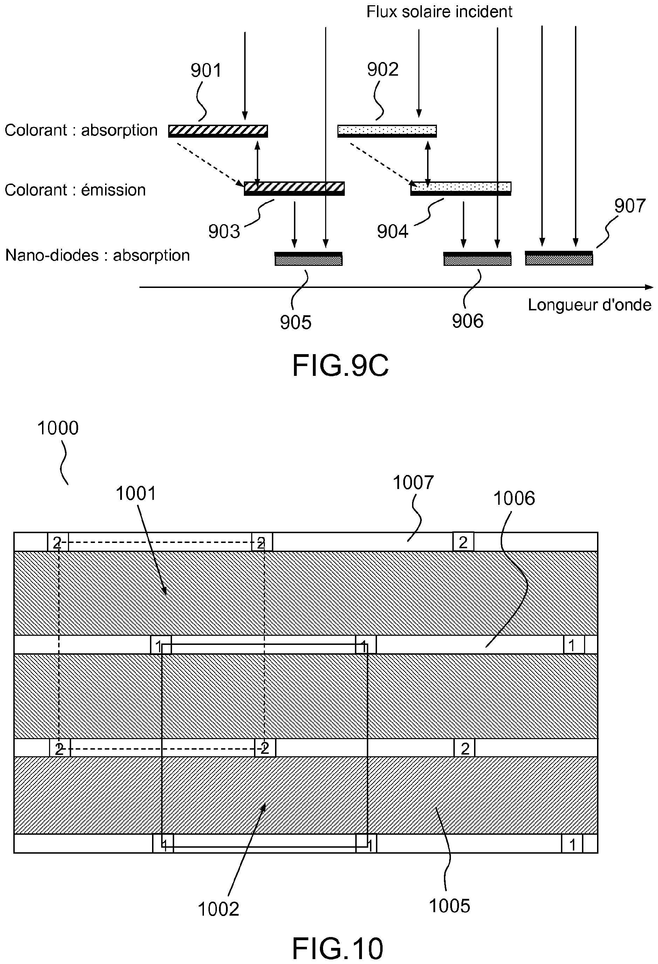

Les figures 8 et 9A illustrent un premier mode de fonctionnement dit « en cascade ». Les photons de plus faibles longueurs d'onde sont absorbés par un premier convertisseur spectral ou colorant (spectre d'absorption symbolisé par la bande 901, figure 9A) dont la plage d'absorption est indiquée par la plage hachurée 801 sur la figure 8, puis réémis (spectre d'émission 903) à une longueur d'onde plus grande (bande d'émission indiquée par la flèche E₁, figure 8). Sur les figures 9A, 9B et 9C, les flèches en pointillés représentent les flux d'énergie liés à la conversion spectrale interne aux colorants et les flèches en traits pleins les flux radiatifs entre molécules du colorant ou vers une nano-cellule. Ces photons sont ensuite absorbés par un deuxième convertisseur spectral (spectre d'absorption 902, figure 9A) choisi pour que sa bande d'absorption (zone hachurée 802 figure 8) couvre la bande d'émission E₁ du premier convertisseur spectral, puis réémis (spectre d'émission 904) à une longueur d'onde toujours plus grande (bande d'émission indiquée par la flèche E₂). On peut ainsi couvrir le spectre solaire par un ensemble de convertisseurs spectraux différents. La plage d'absorption du convertisseur spectral de rang i (i étant choisi croissant pour les colorants couvrant des plages de plus grandes longueurs d'onde) doit recouvrir, au moins partiellement, la plage d'émission du convertisseur spectral de rang i-1. Les nano-antennes optiques et le dispositif photovoltaïque qu'elles contiennent sont alors accordés à la longueur d'onde d'émission du dernier convertisseur spectral, celui émettant dans la plage de plus grande longueur d'onde. Les photons subissent ainsi une cascade d'absorption - relaxation - émission depuis leur absorption initiale par le premier convertisseur spectral jusqu'à l'absorption par une des nano-cellules (spectre d'absorption 906, figure 9A). Cette approche permet de couvrir tout le spectre solaire avec seulement un seul type de nano-cellules. Ces dernières pourront donc être, comme décrit plus haut, optimisées pour l'absorption des photons à la longueur de résonance. Cependant la conversion en longueur d'onde réalisée par chaque colorant entre l'absorption et l'émission d'un photon se traduit par une perte d'énergie dissipée sous forme de chaleur (mécanisme de relaxation évoqué plus haut). Il peut en résulter une perte dans le processus de conversion électrique (par exemple un photon de 330 nm converti en un photon de 1000 nm aura perdu les 2/3 de son énergie avant d'être converti en énergie électrique sous une tension de l'ordre de IV aux bornes d'une jonction en GaAs) et l'échauffement du colorant qui peut se traduire par un vieillissement précoce de ce dernier. Notons que cette perte d'énergie dans le processus de conversion est identique à celle observée dans les cellules solaires classiques et conduit à un rendement de conversion maximum de 32 % pour une cellule simple jonction.

La figure 9B illustre le mode parallèle. Dans ce mode, on associe autant de types de nano-antennes que de types de convertisseurs spectraux. Il est en effet possible d'agencer plusieurs nano-antennes différentes, par exemple de type MIM et de maintenir pour chaque résonance associée à chaque type de nano-antennes une absorption quasi-totale. L'ingénierie de la réponse spectrale de cet assemblage permet, dans le cas de l'invention, de réaliser un plan parfaitement absorbant sur un ensemble de pages spectrales. Chaque groupe convertisseur spectral - nano-cellule permet donc, dans une configuration optimisée, une absorption quasi-totale sur la plage spectrale correspondant à la réunion de celles de l'absorption et de l'émission du convertisseur spectral. Les photons incidents dans la plage d'absorption de chaque convertisseur spectral sont absorbés (spectres d'absorption 901, 902) par celui-ci puis réémis (spectres d'émission 903, 904) dans la plage d'émission avant d'être absorbés par la nano-cellule associée (spectres d'absorption 905, 906). D'autre part les photons incidents dans la plage d'absorption de la nano-cellule sont directement absorbés par cette dernière. Les nano-antennes sont chargées par des empilements de couches en matériau semi-conducteur dont l'énergie de bande interdite est adaptée à la longueur d'onde de résonance de l'antenne. Ainsi il existe une conversion électrique adaptée au mieux à l'émission de chaque convertisseur spectral. Les photons émis par un convertisseur spectral sont absorbés par les nano-antennes adaptées à cette longueur d'onde. Ils sont alors convertis avec une perte en énergie nettement réduite par rapport au cas précédent (un photon de 330 nm pourra, par exemple, être converti en énergie électrique à plus de 90 % sous une tension de plus de 3 V aux bornes d'une jonction en ZnO). On couvrira au mieux le spectre solaire en assemblant « à la demande » les groupes convertisseur spectral - nano-cellule. On pourra, en particulier, assurer une couverture totale des zones spectrales donnant un fort rayonnement solaire (typiquement entre 450 et 750 nm) et laisser des plages libres de toute absorption entre ces groupes dans les zones spectrales où le rayonnement solaire au niveau du sol est particulièrement faible, par exemple au voisinage des longueurs d'onde 940 et 1120 nm (voir par exemple le spectre 800, figure 8).

La figure 9C illustre le cas du mode mixte. Dans ce mode de fonctionnement, des nano-cellules de types différents sont associées respectivement à des convertisseurs spectraux comme cela a été décrit dans le fonctionnement en mode parallèle. D'autres types de nano-cellules sont insérés qui ne sont pas associées à un convertisseur spectral et permettent une absorption directe (spectre d'absorption 907).

Dans les modes de fonctionnement parallèle ou mixte, il convient de relier électriquement l'ensemble des nano-cellules d'un même type. Un exemple de connexion est illustré sur la figure 10 pour deux types de nano-cellules « 1 » et « 2 ». Le plan métallique inférieur (non visible sur la figure) est utilisé comme électrode commune, et des réseaux de lignes électriques 1006, 1007 relient les parties supérieures des nano-antennes de même type, respectivement 1 et 2. Ces lignes électriques seront avantageusement réalisées en structurant la couche de ZnO dopé aluminium (notée 506 figure 5G) décrite dans le procédé de réalisation ci-dessus déposée sur la couche d'encapsulation 1005, par exemple en ZnO (couche 505, figure 5E). Les carrés 1001, 1002 représentent la section efficace d'absorption des nano-antennes « 1 » et « 2 » respectivement, placées en leur centre. Le pavage, à l'aide de ces sections efficaces, de la totalité du plan inférieur du composant photovoltaïque de l'invention, assure à la résonance une absorption quasi-totale des photons incidents par le nano-cellules correspondant à cette résonance. Ce pavage pourra être périodique. Le rendement de conversion maximal théorique de ce système multi-jonctions n'est plus limité à 32 % comme dans le cas précédent. Il dépend fortement du nombre de types de nano-cellules utilisé. Pour un nombre infini de celles-ci, il est de 86.8 % pour un éclairage direct. Pour des nano-antennes de dimension latérale de l'ordre de λ/10, disposées dans un agencement périodique de période λ/2, il est faisable d'utiliser trois, voire quatre, types de nano-cellules différents. Pour quatre types de cellules, le rendement optimal pour un éclairage direct est de 68.8 %, soit plus de deux fois celui d'une simple jonction.

D'une manière générale on pourra concevoir des systèmes alliant selon les plages spectrales l'organisation de type « cascade » et l'organisation de type « parallèle ». En particulier on pourra insérer une ou plusieurs types de nano-cellules qui ne seront pas associés à un colorant.

Bien que décrite à travers un certain nombre d'exemples de réalisation détaillés, le composant photovoltaïque et la méthode de fabrication dudit composant comprennent différentes variantes, modifications et perfectionnements qui apparaîtront de façon évidente à l'homme de l'art.

En particulier, les nano-antennes optiques peuvent être chargées par un autre empilement que celui constituant une jonction P/N. En fait toute structure photovoltaïque est acceptable à condition que son épaisseur permette l'obtention par la nano-antenne d'une résonance adaptée à la longueur d'onde d'émission du colorant. Par ailleurs, bien que la description ait été faite au moyen de résonateurs de type MIM, d'autres résonateurs électromagnétiques peuvent être envisagés qui présentent aussi une fonction de nano-antenne optique pour la concentration spatiale du flux solaire.

## Revendications

1. Composant photovoltaïque (100) comprenant :
- Au moins un premier ensemble de nano-cellules photovoltaïques (101) comprenant chacune une nano-antenne optique présentant une résonance électromagnétique dans une première bande spectrale de résonance, au moins une dimension latérale de la nano-antenne optique étant inférieure à une longueur d'onde centrale de la dite première bande spectrale de résonance,
- une couche de conversion spectrale (107) permettant la conversion d'au moins une partie du spectre solaire vers ladite première bande spectrale de résonance.

2. Composant photovoltaïque selon la revendication 1 comprenant une première couche métallique continue (104, 304), et dans lequel chaque nano-cellule photovoltaïque (101, 301) comprend un empilement structuré d'une première couche diélectrique (103, 303) et d'une seconde couche métallique (102, 302) pour former avec la première couche métallique continue une nano-antenne optique de type MIM dont au moins une dimension latérale est inférieure à une longueur d'onde centrale de la dite première bande spectrale de résonance,.

3. Composant photovoltaïque selon la revendication 2, dans lequel ladite couche diélectrique (303) comprend un empilement de couches en matériau semi-conducteur (315, 314, 313), dont au moins une couche (314) en matériau semi-conducteur absorbant dans ladite première bande spectrale de résonance et une couche ou un empilement de couches (313) en matériau semi-conducteur dopé assurant le contact électrique avec la seconde couche métallique.

4. Composant photovoltaïque selon la revendication 3, dans lequel seule la couche ou empilement de couches en matériau semi-conducteur dopé (313) assurant le contact électrique avec la seconde couche métallique est structuré(e).

5. Composant photovoltaïque selon l'une quelconque des revendications 2 à 4, dans lequel une dimension latérale de chaque nano-antenne optique MIM est inférieure à λ₀/5 où λ₀ est une longueur d'onde centrale de ladite première bande spectrale de résonance.

6. Composant photovoltaïque selon l'une quelconque des revendications 2 à 5, dans lequel lesdites nano-antennes optiques MIM présentent une forme de ruban et sont disposées selon une orientation principale et dans lequel les secondes couches métalliques d'au moins une partie des nano-antennes optiques MIM sont reliées pour former un contact électrique supérieur pour le premier ensemble de nano-cellules photovoltaïques.

7. Composant photovoltaïque selon la revendication 6, dans lequel les nano-antennes optiques MIM présentent une forme de ruban dont la largeur varie à une échelle sub longueur d'onde.

8. Composant photovoltaïque selon l'une quelconque des revendications 2 à 5, dans lequel lesdites nano-antennes optiques MIM présentent une forme de plot et sont disposées selon deux directions principales, ledit composant comprenant en outre une couche d'encapsulation isolante électriquement et transparente entre les plots et une couche conductrice transparente en contact avec les deuxièmes couches métalliques d'au moins une partie des nano-antennes optiques pour former un contact électrique supérieur pour le premier ensemble de nano-cellules photovoltaïques.

9. Composant photovoltaïque selon l'une quelconque des revendications précédentes, dans lequel la couche de conversion spectrale comprend un ou plusieurs matériaux de conversion spectrale insérés dans une matrice solide ou liquide.

10. Composant photovoltaïque selon l'une quelconque des revendications précédentes, dans lequel ladite couche de conversion spectrale comprend au moins deux matériaux de conversion spectrale, le spectre d'absorption du second matériau recouvrant le spectre d'émission effective du premier matériau et le spectre d'émission effective du second matériau étant au moins partiellement superposé avec ladite première bande spectrale de résonance.

11. Composant photovoltaïque selon l'une quelconque des revendications précédentes, comprenant au moins un premier ensemble de nano-cellules photovoltaïques comprenant chacune une nano-antenne optique présentant une première bande spectrale de résonance et un deuxième ensemble de nano-cellules photovoltaïques comprenant chacune une nano-antenne optique présentant une deuxième bande spectrale de résonance.

12. Composant photovoltaïque selon la revendication 11, dans lequel la couche de conversion spectrale comprend au moins un matériau de conversion spectrale permettant la conversion d'au moins une partie du spectre solaire vers les première et deuxième bandes spectrales de résonance.

13. Composant photovoltaïque selon la revendication 11, dans lequel la couche de conversion spectrale comprend au moins deux matériaux de conversion spectrale, chacun desdits matériaux de conversion spectral permettant la conversion d'au moins une partie du spectre solaire vers chacune desdites première et deuxième bandes spectrales de résonance.

14. Composant photovoltaïque selon l'une quelconque des revendications précédentes, comprenant en outre un ensemble de nano-cellules photovoltaïques comprenant chacune une nano-antenne optique dont la bande spectrale de résonance est adaptée à l'absorption directe d'une partie du spectre solaire.

15. Méthode de fabrication d'un composant photovoltaïque selon l'une quelconque des revendications précédentes comprenant :
- Le dépôt sur un substrat métallisé d'un empilement de couches en matériau semi-conducteur dont une couche absorbante dans ladite première bande spectrale de résonance;
- Le dépôt d'une couche métallique structurée ;
- La gravure auto-alignée d'au moins une partie desdites couches en matériau semi-conducteur;
- Le dépôt d'une couche d'encapsulation et d'une couche de contact supérieur en matériau conducteur transparent.

16. Méthode de fabrication selon la revendication 15, dans laquelle l'étape de dépôt comprend la réalisation par épitaxie sur un substrat adapté dudit empilement de couches en matériau semi-conducteur et le report desdites couches en matériau semi-conducteur sur le substrat métallisé.

## Patentansprüche

1. Fotovoltaikkomponente (100), umfassend:
- wenigstens eine erste Anordnung von fotovoltaischen Nanozellen (101), welche jeweils eine optische Nanoantenne mit einer elektromagnetischen Resonanz in einem ersten spektralen Resonanzband umfassen, wobei wenigstens eine laterale Ausdehnung der optische Nanoantenne kleiner als eine zentrale Wellenlänge des ersten spektralen Resonanzbands ist,
- eine Spektrumwandlungsschicht (107), welche die Wandlung wenigstens eines Teils des Sonnenspektrums in das erste spektrale Resonanzband ermöglicht.

2. Fotovoltaikkomponente nach Anspruch 1, umfassend eine erste durchgängige metallische Schicht (104, 304) und wobei jede fotovoltaische Nanozelle (101, 301) eine Stapelstruktur aus einer ersten dielektrischen Schicht (103, 303) und einer zweiten metallischen Schicht (102, 302) umfasst, um mit der ersten durchgängigen metallischen Schicht eine optische Nanoantenne vom Typ MIM zu bilden, deren wenigstens eine laterale Ausdehnung kleiner als eine zentrale Wellenlänge des ersten spektralen Resonanzbands ist.

3. Fotovoltaikkomponente nach Anspruch 2, wobei die dielektrische Schicht (303) einen Stapel von Schichten aus Halbleitermaterial (315, 314, 313) umfasst, von welchen wenigstens eine Schicht (314) aus einem Halbleitermaterial ist, das in dem ersten spektralen Resonanzband absorbierend ist, und von welchen eine Schicht oder ein Stapel von Schichten (313) aus einem dotierten Halbleitermaterial ist, welches einen elektrischen Kontakt mit der zweiten metallischen Schicht sicherstellt.

4. Fotovoltaikkomponente nach Anspruch 3, wobei nur die Schicht oder der Stapel von Schichten aus dem dotierten Halbleitermaterial (313), welches den elektrischen Kontakt mit der zweiten metallischen Schicht sicherstellt, strukturiert ist/sind.

5. Fotovoltaikkomponente nach einem der Ansprüche 2 bis 4, wobei eine laterale Ausdehnung einer jeden optischen Nanoantenne MIM kleiner ist als λ₀ / 5, wobei λ₀ eine zentrale Wellenlänge des ersten spektralen Resonanzbands ist.

6. Fotovoltaikkomponente nach einem der Ansprüche 2 bis 5, wobei die optischen Nanoantennen MIM eine Bandform aufweisen und in einer Hauptorientierung angeordnet sind und wobei die zweiten metallischen Schichten wenigstens eines Teils der optischen Nanoantennen MIM miteinander verbunden sind, um einen oberen elektrischen Kontakt für die erste Anordnung von fotovoltaischen Nanozellen zu bilden.

7. Fotovoltaikkomponente nach Anspruch 6, wobei die optischen Nanoantennen MIM eine Bandform aufweisen, dessen Breite in der Größenordnung kleiner als die Wellenlänge variiert.

8. Fotovoltaikkomponente nach einem der Ansprüche 2 bis 5, wobei die optischen Nanoantennen MIM eine Blockform aufweisen und in zwei Hauptrichtungen angeordnet sind, wobei die Komponente ferner eine elektrisch isolierende, transparente Kapselschicht zwischen den Blöcken und eine leitende transparente Schicht, die mit den zweiten metallischen Schichten wenigstens eines Teils der optischen Nanoantennen in Kontakt ist, umfasst, um einen oberen elektrischen Kontakt für die erste Anordnung von fotovoltaischen Nanozellen zu bilden.

9. Fotovoltaikkomponente nach einem der voranstehenden Ansprüche, wobei die Spektrumwandlungsschicht ein oder mehrere Spektrumwandlungsmaterialien umfasst, welche in einer festen oder flüssigen Matrix enthalten sind.

10. Fotovoltaikkomponente nach einem der voranstehenden Ansprüche, wobei die Spektrumwandlungsschicht wenigstens zwei Spektrumwandlungsmaterialien umfasst, wobei das Absorptionsspektrum des zweiten Materials das effektive Emissionsspektrum des ersten Materials abdeckt und das effektive Emissionsspektrum des zweiten Materials wenigstens teilweise mit dem ersten spektralen Resonanzband überlappt.

11. Fotovoltaikkomponente nach einem der voranstehenden Ansprüche, umfassend wenigstens eine erste Anordnung von fotovoltaischen Nanozellen, welche jeweils eine optische Nanoantenne mit einem ersten spektralen Resonanzband umfassen, und eine zweite Anordnung von fotovoltaischen Nanozellen, welche jeweils eine optische Nanoantenne mit einem zweiten spektralen Resonanzband umfassen.

12. Fotovoltaikkomponente nach Anspruch 11, wobei die Spektrumwandlungsschicht wenigstens ein Spektrumwandlungsmaterial umfasst, welches die Wandlung wenigstens eines Teils des Sonnenspektrums in das erste und zweite spektrale Resonanzband ermöglicht.

13. Fotovoltaikkomponente nach Anspruch 11, wobei die Spektrumwandlungsschicht wenigstens zwei Spektrumwandlungsmaterialien umfasst, wobei jedes der Spektrumwandlungsmaterialien die Wandlung wenigstens eines Teils des Sonnenspektrums in sowohl das erste als auch das zweite spektrale Resonanzband ermöglicht.

14. Fotovoltaikkomponente nach einem der voranstehenden Ansprüche, ferner umfassend eine Anordnung von fotovoltaischen Nanozellen, welche jeweils eine optische Nanoantenne umfassen, dessen spektrales Resonanzband geeignet ist, einen Teil des Sonnenspektrums direkt zu absorbieren.

15. Verfahren zum Herstellen einer Fotovoltaikkomponente nach einem der voranstehenden Ansprüche, umfassend:
- Legen, auf ein metallisches Substrat, eines Stapel von Schichten aus Halbleitermaterial, von welchen eine Schicht in dem ersten spektralen Resonanzband absorbierend ist;
- Legen einer strukturierten metallischen Schicht;
- selbstausrichtendes Ätzen wenigstens eines Teils der Schichten aus Halbleitermaterial;
- Legen einer Kapselschicht und einer oberen Kontaktschicht aus einem leitenden transparenten Material.

16. Verfahren zum Herstellen nach Anspruch 15, wobei der Schritt des Legens umfasst: Wachsen des Stapels von Schichten aus Halbleitermaterial durch Epitaxie auf einem geeigneten Substrat und Transferieren der Schichten aus Halbleitermaterial auf das metallische Substrat.

## Claims

1. A photovoltaic component (100) comprising:
- at least one first array of photovoltaic nano-cells (101) each comprising an optical nano-antenna exhibiting an electromagnetic resonance in a first resonant spectral band, at least one lateral dimension of the optical nano-antenna being smaller in size than a central wavelength of said first resonant spectral band; and
- a spectral conversion layer (107) allowing at least part of the solar spectrum to be converted to said first resonant spectral band.

2. The photovoltaic component according to Claim 1 comprising a continuous first metal layer (104, 304), and in which each photovoltaic nano-cell (101, 301) comprises a structured multilayer of a first dielectric layer (103, 303) and of a second metal layer (102, 302) to form, with the continuous first metal layer, an optical nano-antenna of the MIM type at least one lateral dimension of which is smaller in size than a central wavelength of said first resonant spectral band.

3. The photovoltaic component according to Claim 2, in which said dielectric layer (303) comprises a multilayer of semiconductor layers (315, 314, 313), at least one layer (314) of which is made of a semiconductor that is absorbent in said first resonant spectral band, and one layer or multilayer (313) of which is made of a doped semiconductor ensuring electrical contact with the second metal layer.

4. The hotovoltaic component according to Claim 3, in which only the layer or multilayer (313) made of the doped semiconductor ensuring the electrical contact with the second metal layer is structured.

5. The photovoltaic component according to any one of Claims 2 to 4, in which a lateral dimension of each optical MIM nano-antenna is smaller than λ₀/5 where λ₀ is a central wavelength of said first resonant spectral band.

6. The photovoltaic component according to any one of Claims 2 to 5, in which said optical MIM nano-antennae have a strip form and are placed with a principle orientation, and in which the second metal layers of at least some of the optical MIM nano-antennae are connected to form an upper electrical contact for the first array of photovoltaic nano-cells.

7. The photovoltaic component according to Claim 6, in which the optical MIM nano-antennae have a strip form the width of which varies on a subwavelength scale.

8. The photovoltaic component according to one of Claims 2 to 5, in which said optical MIM nano-antennae have a pad form and are placed in two principal directions, said component furthermore comprising an electrically insulating and transparent encapsulation layer between the pads, and a transparent conductive layer making contact with the second metal layers of at least some of the optical nano-antennae in order to form an upper electrical contact for the first array of photovoltaic nano-cells.

9. The photovoltaic component according to any one of the preceding claims, in which the spectral conversion layer comprises one or more spectral conversion materials inserted in a solid or liquid matrix.

10. The photovoltaic component according to any one of the preceding claims, in which said spectral conversion layer comprises at least two spectral conversion materials, the absorption spectrum of the second material covering the effective emission spectrum of the first material, and the effective emission spectrum of the second material being at least partially superposed with said first resonant spectral band.

11. The photovoltaic component according to any one of the preceding claims, comprising at least one first array of photovoltaic nano-cells each comprising an optical nano-antenna having a first resonant spectral band, and a second array of photovoltaic nano-cells each comprising an optical nano-antenna having a second resonant spectral band.

12. The photovoltaic component according to Claim 11, in which the spectral conversion layer comprises at least one spectral conversion material allowing at least part of the solar spectrum to be converted to the first and second resonant spectral bands.

13. The photovoltaic component according to Claim 11, in which the spectral conversion layer comprises at least two spectral conversion materials, each of said spectral conversion materials allowing at least part of the solar spectrum to be converted to each of said first and second resonant spectral bands.

14. The photovoltaic component according to any one of the preceding claims, furthermore comprising an array of photovoltaic nano-cells each comprising an optical nano-antenna the resonant spectral band of which is adapted for direct absorption of part of the solar spectrum.

15. A method for manufacturing a photovoltaic component according to any one of the preceding claims, comprising:
- depositing, on a metallized substrate, a multilayer of semiconductor layers one layer of which is absorbent in said first resonant spectral band;
- depositing a structured metal layer;
- self-aligned etching of at least some of said semiconductor layers; and
- depositing an encapsulation layer and an upper contact layer made of a transparent conductive material.

16. The manufacturing method according to Claim 15, in which the deposition step comprises growing by epitaxy on a suitable substrate said multilayer of semiconductor layers, and transferring said semiconductor layers to the metallized substrate.
